Europäisches Patentamt

European Patent Office

Office européen des brevets

(19)

(11) **EP 1 107 011 A1**

(12) **DEMANDE DE BREVET EUROPEEN**

(43) Date de publication:
**13.06.2001 Bulletin 2001/24**

(51) Int Cl.$^7$: **G01R 31/26**

(21) Numéro de dépôt: **00403300.7**

(22) Date de dépôt: **24.11.2000**

(84) Etats contractants désignés:
**AT BE CH CY DE DK ES FI FR GB GR IE IT LI LU
MC NL PT SE TR**
Etats d'extension désignés:
**AL LT LV MK RO SI**

(30) Priorité: **30.11.1999 FR 9915094**

(71) Demandeur: **THOMSON-CSF
75008 Paris (FR)**

(72) Inventeurs:
• **Tolant, Clément
94117 Arcueil Cedex (FR)**
• **Cordier, Joel
94117 Arcueil Cedex (FR)**
• **Eudeline, Philippe
94117 Arcueil Cedex (FR)**
• **Servain, Patrick
94117 Arcueil Cedex (FR)**

(74) Mandataire: **Lucas, Laurent Jacques
Thomson-CSF
Propriété Intellectuelle
13, avenue du Président S. Allende
94117 Arcueil Cedex (FR)**

(54) **Procédé et dispositif de mesure de la température de composants hyperfréquence**

(57) La présente invention concerne un procédé et un dispositif de mesure de la température moyenne de composants.

Une suite d'impulsions de test de durée croissante est appliquée au composant, la puissance des impulsions étant représentative d'un état de fonctionnement du composant, une mesure de température de jonction étant effectuée à la fin de chaque impulsion pour obtenir une courbe représentative (42) de l'évolution de la température de jonction du composant en fonction du temps à partir des points de mesures (41) de température réalisée en fin de chaque impulsion.

Elle s'applique notamment pour la détermination de la température de jonction de composants électroniques hyperfréquence fonctionnant en mode continu ou en mode impulsionnel.

FIG.1

FIG.3a

FIG.3b

FIG.3c

FIG.3d

FIG.4

**Description**

La présente invention concerne un procédé et un dispositif de mesure de la température moyenne de composants. Elle s'applique notamment pour la détermination de la température de jonction de composants électroniques hyperfréquence fonctionnant en mode continu (CW) ou en mode impulsionnel.

Les techniques radar utilisent notamment des circuits hyperfréquence, pouvant véhiculer des puissances importantes tels les déphaseurs, limiteurs ou encore amplificateurs de puissance. Ces derniers parfois dénommés amplificateurs "Etat solide" utilisent notamment des composants hyper à base de semi-conducteurs tels que par exemple des transistors bipolaires de puissance polarisée en classe C. En revanche, les limiteurs et les déphaseurs utilisent le plus souvent des diodes et en particulier des diodes PIN. Ces différents composants fonctionnent généralement selon un mode radar, c'est-à-dire en régime impulsionnel. Dans ce mode de fonctionnement, l'onde est émise par le radar sous forme d'impulsions dont la longueur et la période de répétition peuvent être fixes ou variables dans le temps.

Dans les composants hyperfréquence cités précédemment tels que par exemple les transistors ou les diodes, il est important de connaître la température atteinte par la jonction du composant, car elle détermine la durée de vie de ce dernier. A cet effet, les fabricants fournissent généralement des informations sur les caractéristiques thermiques des composants, et notamment la résistance thermique $R_{th}$ qui est définie par la relation suivante :

$$R_{th} = (\theta_j - \theta_s)/P_d \qquad (1)$$

Où $\theta_j$ est la température de jonction du composant, $\theta_s$ est la température du composant prise au niveau du boîtier et Pd est la puissance dissipée par le composant.

Si cette caractéristique est intéressante pour la connaissance de la température de jonction en mode CW, elle s'avère insuffisant pour traiter les cas en régime pulsé pour lesquels il faudrait introduire le concept d'impédance thermique. En effet, la température de jonction du composant en mode pulsé est fortement liée au type de cadencement hyper utilisé. La prise en compte de l'évolution de la température de jonction est une opération très importante, notamment pour la gestion et la prévision de la durée de vie d'un composant, en particulier pour des calculs de fiabilité ou de sûreté de fonctionnement, mais également pour comprendre des phénomènes particuliers comme par exemple la variation de phase du signal hyperfréquence lors des impulsions successives.

Il existe des méthodes pour déterminer la température de jonction des composants, notamment des transistors. Ces méthodes font appel à des mesures électriques courant-tension. En particulier, on injecte un courant connu dans le transistor et on mesure la variation de sa tension base-émetteur $\Delta V_{BE}$. Ces méthodes sont basées sur une propriété connue des transistors bipolaires selon laquelle, pour un courant constant i donné traversant la jonction base-émetteur, toute variation de température de la jonction donne naissance à une variation de la tension base-émetteur $V_{BE}$ selon une loi linéaire connue. La mesure de la variation de cette tension permet donc, pour un courant injecté connu, de déterminer la variation de température de la jonction.

Ces méthodes permettent uniquement de déterminer la température lorsque l'équilibre thermodynamique du composant est atteint, c'est-à-dire lorsque sa température est pratiquement stabilisée. La grandeur ainsi obtenue correspond à une valeur maximale de la température de jonction du composant. De plus, les cadencements hyperfréquence auxquels sont soumis les composants sous test correspondent généralement à des largeurs d'impulsions et des périodes de répétition fixes. Or ces mesures ne donnent aucune indication sur l'évolution précise de la température de jonction du composant dans les impulsions et hors impulsions pour un cadencement commençant à l'instant t=o et notamment en ce qui concerne de nouveaux modes de fonctionnement radar où les largeurs des impulsions et les périodes de répétition ne sont plus nécessairement fixes au cours d'une même rafale d'impulsions.

Le but de l'invention est de pallier les inconvénients précités pour permettre notamment une indication précise de l'évolution de la température moyenne du composant dans toutes les phases du cadencement hyperfréquence et ceci aussi bien dans les impulsions que hors impulsions.

A cet effet, l'invention a pour objet un procédé de mesure de la température de jonction d'un composant où une suite d'impulsions de test de largeur croissante est appliquée au composant. La puissance hyperfréquence crête des impulsions de test est représentative d'un état de fonctionnement du composant, par exemple l'état de fonctionnement nominal. Une mesure de température de jonction est effectuée à la fin de chaque impulsion pour obtenir une courbe représentative de l'évolution de la température de jonction du composant en fonction du temps à partir des points de mesures de température réalisées en fin de chaque impulsion.

L'invention concerne également un dispositif pour la mise en oeuvre du procédé selon l'invention.

L'invention a pour principaux avantages qu'elle permet une élaboration du profil de température moyenne du composant en fonction des variables de fonctionnement d'un composant, qu'elle permet une amélioration des modèles électrothermiques utilisés pour la simulation des circuits, qu'elle permet une optimisation des circuits électriques, qu'elle permet une meilleure compréhension et une meilleure quantification des influences liées à la température sur les caractéristiques électriques des circuits, notamment en ce qui concerne l'évolution temporelle de leurs caractéristiques électriques, et qu'elle est simple à mettre en oeuvre.

D'autres caractéristiques et avantages de l'invention apparaîtront à l'aide de la description qui suit faite en regard de dessins annexés qui représentent :

- la figure 1, des impulsions illustrant les conditions de fonctionnement hyperfréquence d'un composant fonctionnant en régime impulsionnel ;
- la figure 2, un exemple d'évolution de la température moyenne de jonction d'un composant en fonction de ses caractéristiques statiques ;
- les figures 3a à 3d, un exemple de suites d'impulsions hyperfréquence de tests appliqués à un composant selon le procédé de l'invention, et dans le cas où le régime de fonctionnement nominal du composant est un régime impulsionnel ;
- la figure 4, un exemple de courbe d'évolution de température de jonction du composant précité obtenue par le procédé selon l'invention ;
- la figure 5, des impulsions illustrant les conditions de fonctionnement d'un composant hyperfréquence dans un régime à onde continue démarrant à l'instant $t_o$ ;
- les figures 6a à 6c, un exemple de suites d'impulsions hyperfréquence de tests appliqués à un composant selon le procédé de l'invention, dans le cas où le régime de fonctionnement nominal du composant est un régime continu démarrant à $t_o$ ;
- la figure 7, un exemple de courbe d'évolution de température de jonction du composant précité obtenue par le procédé selon l'invention ;
- la figure 8, un exemple de réalisation d'un dispositif pour la mise en oeuvre du procédé selon l'invention.

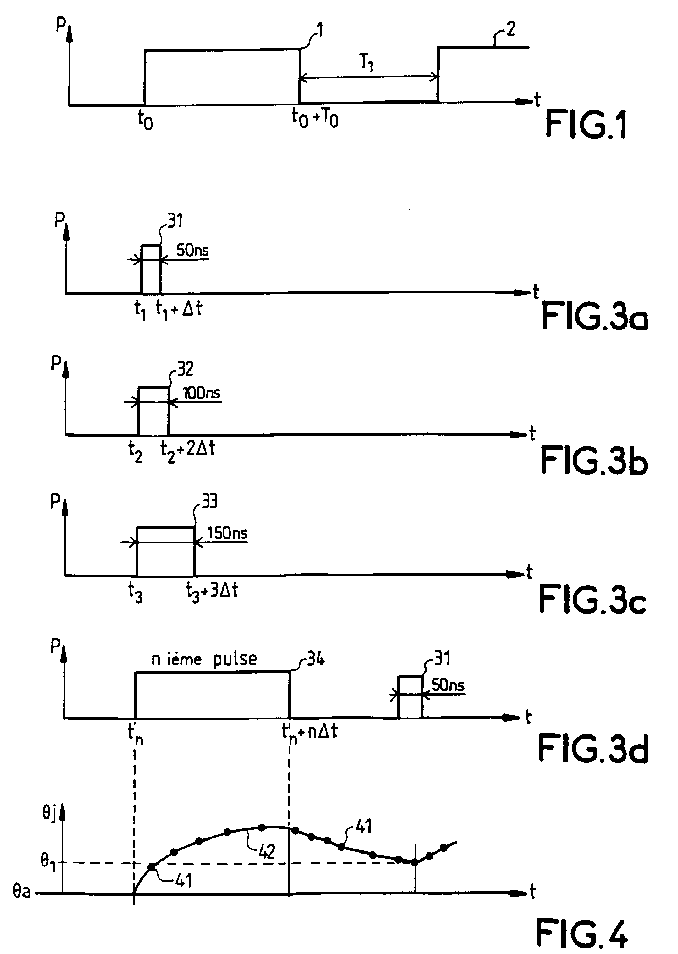

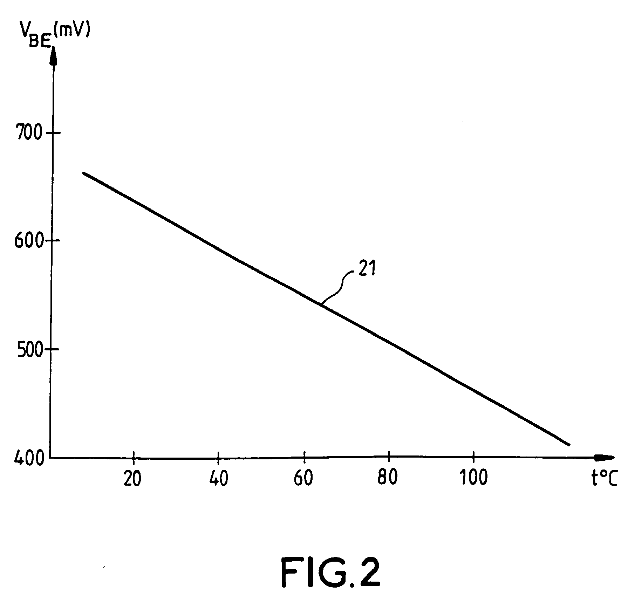

La figure 1 illustre un train d'impulsions hyperfréquence découpées avec une première impulsion 1 et le début d'une deuxième impulsion 2 dans un système d'axes où les ordonnées représentent la puissance hyperfréquence P arrivant sur un composant sous test et les abscisses le temps t. La première impulsion 1 démarre à un temps $t_o$ et se termine un temps $T_0$ plus tard. Ces deux impulsions nominales sont par exemple représentatives d'un mode de fonctionnement radar. Elles représentent en fait les conditions dans lesquelles va évoluer le composant. En particulier la puissance P d'une impulsion incidente est représentative d'un état de fonctionnement instantané du composant.

Selon l'invention, une suite d'impulsions de signaux hyperfréquence de longueur croissante et de puissance de préférence constante sont envoyées dans le composant au moins jusqu'à ce que la durée de dernière impulsion approche la durée $T_0$ de l'impulsion nominale 1. La durée de la dernière impulsion peut par exemple être égale à cette durée $T_0$. Ces impulsions de test croissent par exemple de façon régulière, c'est-à-dire selon un pas de durée constant d'une impulsion à l'autre. La suite d'impulsions est de préférence représentative des conditions de fonctionnement opérationnel du composant, notamment de son évolution dans le temps.

Une mesure de température est effectuée en fin de chaque impulsion, c'est-à-dire lorsque le signal hyperfréquence n'est plus présent sur le composant de telle sorte que seul le courant de mesure, de valeur connue, parcourt le composant, la mesure de la température se faisant à partir d'une méthode en courant-tension classique. Le courant injecté $I_m$ est constant et par exemple de l'ordre de quelques milliampères, il est injecté dans le composant en fin de cycle, lorsque le signal hyperfréquence n'est plus présent en entrée du composant. On relève alors rapidement aux bornes du composant la tension $V_j$ associée. Cette tension est par exemple la tension entre la base et l'émetteur d'un transistor bipolaire ou la tension de jonction d'une diode. Une table représentative de l'évolution des caractéristiques statiques du composant en fonction de la température indique alors de façon connue la température de jonction correspondant au couple ($I_m$, $V_j$) ainsi défini.

La figure 2 illustre cette table représentée sous forme graphique, par une courbe 21, dans un système d'axes, pour un courant de mesure donné. L'axe des ordonnées représente la tension $V_{BE}$ aux bornes de la jonction du composant, qui est par exemple la tension entre la base et l'émetteur d'un transistor bipolaire ou la tension aux bornes d'une jonction de diode. L'axe des abscisses représente la température de la jonction. La courbe 21, peut être facilement mémorisée soit par des valeurs discrètes, soit par une équation mathématique du fait qu'elle présente l'allure d'une droite.

Les figures 3a à 3d illustrent la suite d'impulsions hyperfréquence appliquées sur un composant sous test. Lorsque ces signaux incidents arrivent sur des diodes ou des transistors, la situation thermique et donc la température de jonction des ces composants est modifiée. Il suffit après chaque impulsion de relever rapidement le couple courant-tension (I, V) représentatif de la température de jonction. Entre chaque mesure, il peut être nécessaire d'attendre que la température du composant soit redescendue à la température ambiante initiale.

La figure 3a illustre une première impulsion 31 appliquée à partir d'un temps $t_1$ et pendant une durée $\Delta t$, par exemple de l'ordre de 50 ns. Cette impulsion fait croître la température de jonction du composant. A la fin de cette impulsion, par exemple au temps $t_1 + \Delta t$, une mesure de température de la jonction est réalisée par injection du courant de mesure $I_m$ et mesure de la tension de jonction $V_j$. Lorsque la température de jonction du composant est redescendue à la température ambiante, ou à toute autre température de référence, une deuxième impulsion 32 est appliquée au composant. Cette deuxième impulsion 32 est donc appliquée à partir d'un temps $t_2$ supérieur au temps $t_1$ par exemple pen-

dant une durée $2\Delta t$. Pour mieux illustrer le procédé selon l'invention, les temps $t_1$ et $t_2$, comme les autres temps de début d'impulsions de test évoqués par la suite, sont alignés sur l'ensemble des figures 3a à 3d. La figure 3c illustre le cas de la troisième impulsion de test 33 appliquée au composant hyperfréquence. Cette impulsion est appliquée une fois que la température de jonction est revenue à la température de référence, à partir d'un temps $t_3$ pour une durée par exemple égale à $3\Delta t$.

La figure 3d illustre la $n^{ième}$ mesure, ou mesure d'ordre n, effectuée sur le composant hyperfréquence. Une impulsion 34 de test lui est donc appliquée à partir d'un temps $t_n$ par exemple pour une durée $n\Delta t$. La durée de cette impulsion est par exemple telle qu'elle soit égale à la durée $T_0$ de l'impulsion nominale 1. Si les impulsions croissent régulièrement selon le pas $\Delta t$, ce dernier est alors par exemple calculé en fonction de la durée $T_0$ de l'impulsion nominale de telle sorte que le pas de durée $\Delta t$ soit sensiblement égal à $T_0/n$.

Pour mesurer l'évolution de la température de jonction entre la première impulsion nominale 1 et la deuxième impulsion nominale 2, le courant de test injecté dans le composant hyperfréquence reste présent et constant dans le composant hyperfréquence après la $n^{ième}$ impulsion de test appliquée au composant. Des échantillons de tensions aux bornes de la jonction du composant sont alors prélevés, par exemple régulièrement selon le pas $\Delta t$, pour définir l'évolution de la température entre les deux impulsions 1, 2.

Le courant de mesure $I_m$ est par exemple maintenu dans le composant pendant la durée $T_1$ d'inter-impulsion comprise entre la première impulsion nominale 1 et la deuxième impulsion nominale 2. Pendant cette durée $T_1$ des valeurs de tension de jonction continuent à être échantillonnées pour déterminer des points de mesure de température de jonction entre les deux impulsions 1,2. Au bout de $T_1$, le courant de mesure est par exemple supprimé du composant et une nouvelle suite d'impulsions de test est alors appliquée au composant, en commençant par la première impulsion 31 de la suite, d'une durée $\Delta t$ comme pour la précédente suite, mais éventuellement différente. La nouvelle température de référence de la jonction n'est plus la même que lors de la première suite d'impulsion de test. Ce n'est notamment plus la température ambiante mais la température $\theta_1$ de la jonction atteinte en fin de période inter-impulsion, juste avant le début de la deuxième impulsion nominale 2. A cet effet, la première impulsion de test 31 est envoyée juste après la durée $T_1$ d'inter-impulsion.

La figure 4 illustre l'allure de température de jonction $\theta_j$ obtenue en fonction du temps t à partir d'une température de référence $\theta_a$, par exemple la température ambiante. Les mesures de température effectuées en fin d'impulsion de test à l'intérieur de la durée d'impulsion et en dehors donnent des points de mesures 41 à partir desquels une courbe de température de jonction 42 peut être définie par extrapolation, linéaire ou quadratique par exemple. La courbe de température correspondant à la deuxième impulsion nominale 2 débute à partir de la température $\theta_1$ précitée. La précision de cette mesure de la température de jonction $\theta_j$ entre les impulsions n'est pas parfaite, du fait que le courant de mesure peut influencer légèrement la situation thermique du composant. Pour des mesures plus précises, on peut traiter le cas inter-impulsions, c'est-à-dire entre les impulsions, comme une mesure intra-impulsion, c'est-à-dire à l'intérieur d'une même impulsion, en injectant successivement les impulsions hyperfréquences de test associées à des mesures courant-tension (I, V) à différents endroits de la région inter-impulsions, en injectant notamment successivement en des temps décalés des impulsions de courant nécessaires à la mesure de la température.

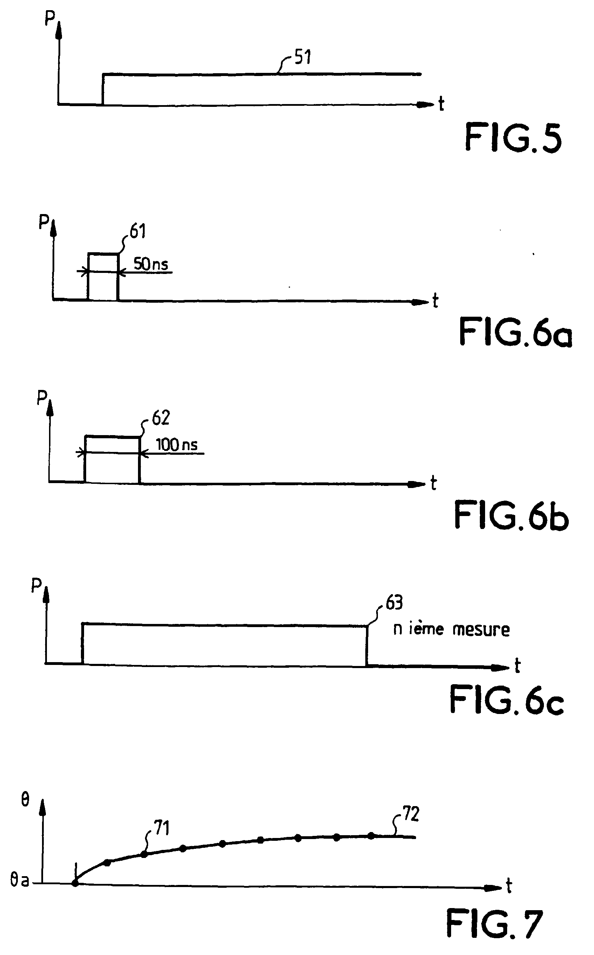

Le procédé selon l'invention peut aussi s'appliquer dans le cas où le composant hyperfréquence est soumis à un régime d'onde continue démarrant à un instant to comme l'illustre la courbe 51 de la figure 5. Cette courbe 51 montre les conditions dans lesquelles va évoluer le composant par la représentation de sa puissance incidente P en fonction du temps t. Une suite n impulsions de test 61, 62, 63 peut être appliquée au composant de façon analogue à la suite appliquée au composant à l'intérieur d'une même impulsion nominale tel que décrit dans le cas du régime impulsionnel précédent. Ces n impulsions de test sont illustrées par les figures 6a, 6b et 6c. L'injection du courant de mesure $I_m$ dans le composant se fait en fin d'impulsion de test, c'est-à-dire lorsque le signal hyperfréquence produit par l'impulsion de test n'est plus présent sur le composant.

La figure 7 illustre une courbe 72 représentative de l'évolution en température de la jonction du composant à partir d'une température de référence, par exemple la température ambiante $\theta_a$. Cette courbe est obtenue par extrapolation à partir des n points de mesure de température 71 obtenus après chaque impulsion de test. La $n^{ième}$ et dernière impulsion 63 de la suite est par exemple telle qu'elle donne une mesure de température identique à celle produite par l'impulsion précédente d'ordre n-1. La dernière impulsion 63 correspond alors au régime thermique stabilisé.

Une mesure de température est initialisée par la fin d'une impulsion de test 31, 32, 33, 34, 61, 62, 63 par injection du courant de mesure $I_m$ dans le composant. Pour la mise en oeuvre de cette mesure, il est par exemple possible de prévoir de commander le circuit de génération du courant de mesure $I_m$ à partir du front descendant des impulsions de test. Le courant injecté dans le composant est de type pulsé avec une longueur d'impulsion très faible, de l'ordre de quelques nanosecondes et en rapport avec le temps nécessaire pour relever la tension correspondante. Cette impulsion de courant peut être commandée par exemple par un générateur de courant commuté.

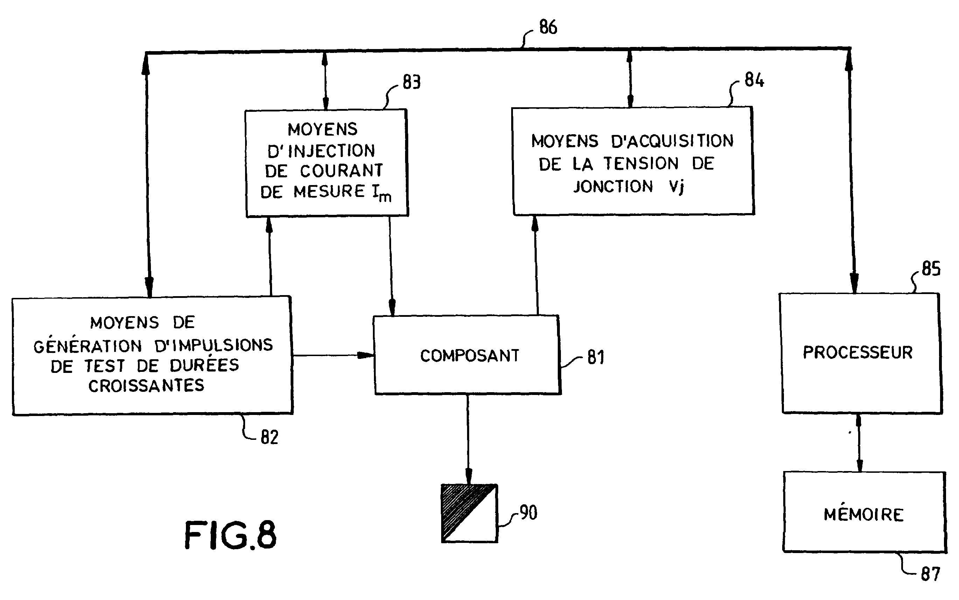

La figure 8 illustre par exemple un banc de mesure pour la mise en oeuvre du procédé selon l'invention. Il permet les mesures de températures précédemment décrites sur un composant 81. En test ce composant est relié à une charge hyperfréquence 90, par exemple une charge 50 ohm. Un tel banc est simple à réaliser. Il peut notamment être réalisé à partir de processeurs, de circuits à mémoire et d'interrupteurs/commutateurs. Le ou les processeurs doivent être en mesure d'effectuer des traitements rapides. Les mémoires de stockage doivent posséder une grande capacité. Les interrupteurs doivent présenter de grandes vitesses de commutation. Les circuits d'interconnexions doivent par ailleurs fournir de hauts débits de données. Tous ces types de circuits peuvent se trouver facilement dans le commerce et faire l'objet d'une association sans difficultés.

Le banc de mesure comporte donc des moyens 82 pour générer des impulsions hyperfréquence de test de durées croissantes. Il doit en effet permettre de générer des impulsions hyperfréquence de test pour le composant ayant des largeurs variables et démarrant à des instants précis. Cette fonction peut être par exemple assurée par une synthèse numérique d'impulsion comportant une mémoire à grande capacité de stockage associée à un bus à haut débit. Les largeurs d'impulsion de test minimales peuvent par exemple être de l'ordre de 30 ns. La largeur des impulsions, et notamment le pas $\Delta t$ d'une impulsion à l'autre peuvent être obtenus par programmation à partir des largeurs d'impulsion nominales auxquelles doit être soumis le composant. Toute la technologie des commandes précédentes, ainsi que le traitement et la visualisation des données peut être commandée par un logiciel de commerce. Les moyens de génération d'impulsions hyperfréquence de test comportent classiquement une carte de génération d'impulsions associée à un générateur et un découpeur hyperfréquence.

Le banc de mesure comporte des moyens 83 pour injecter un courant de mesure $I_m$, constant et de valeur connue précédemment, dans le composant en fin de chaque impulsion hyperfréquence de test. Cette injection étant par exemple commandée par le front descendant de l'impulsion. Il comporte aussi des moyens 84 d'acquisition de la tension $V_j$ aux bornes de la jonction du composant. Cette acquisition est par exemple faite par un convertisseur analogique-numérique à grande rapidité de conversion. Un codage sur 8 bits peut être suffisant. Pour un tel nombre de bits de conversion, il est aisé de trouver des convertisseurs rapides à bon marché.

Les moyens précédents 82, 83, 84 sont reliés à un processeur 85 par un bus 86 de préférence à haut débit. Ce processeur 86 commande tous ces moyens par des interfaces appropriées. Le processeur est par ailleurs relié à une mémoire 87. Cette mémoire comporte une partie de mémoire morte qui contient notamment les différents programmes de test possible mais aussi par exemple des tables de conversion de tension de jonction en température de jonction telles qu'illustrées par la figure 2. Cette partie de mémoire comporte par exemple aussi des paramètres d'équations. La mémoire 87 comporte aussi une partie de mémoire vive notamment pour stocker les mesures de tension fournies par les moyens 84 d'acquisition ainsi que pour stocker les points de mesures de températures 41, 71 indiquant l'évolution en température du composant 81. Des moyens de visualisation non représentés peuvent être prévus pour illustrer les courbes 42, 72 d'évolution de la température.

L'invention apporte certains avantages. Elle permet une élaboration du profil de température du composant quel que soit le type de cadencement retenu. Elle permet donc une amélioration des modèles utilisés pour la simulation thermoélectrique des circuits grâce à un suivi précis de l'évolution en température d'un composant sous test. Elle permet une optimisation des circuits électriques par cette mesure plus précise de la température de jonction. Elle permet par ailleurs une meilleure compréhension et une meilleure quantification des influences liées à la température sur les caractéristiques électriques des circuits, notamment en ce qui concerne par exemple l'évolution de la phase du signal hyperfréquence lors des impulsions successives.

L'invention a été décrite pour la mesure de l'évolution de température de jonction de composants hyperfréquence. Ces composants peuvent notamment être des transistors ou des diodes. Dans le cas de transistors bipolaires la tension de jonction correspond à la tension entre la base et l'émetteur.

La mesure de température de jonction du composant a été décrite par une injection de courant continue accompagnée d'une mesure de tension de jonction en fin d'impulsion hyperfréquence. Il est néanmoins possible d'appliquer le procédé selon l'invention avec une autre méthode de mesure de la température et à d'autres types de composants.

## Revendications

1. Procédé de mesure de température de jonction d'un composant hyperfréquence, caractérisé en ce qu'une suite d'impulsions hyperfréquence de test (31, 32, 33, 34) de durées croissantes est appliquée au composant (81), une mesure de température de jonction étant effectuée à la fin de chaque impulsion pour obtenir une courbe représentative (42, 72) de l'évolution de la température de jonction du composant en fonction du temps à partir des points de mesures (41, 71) de température réalisés en fin de chaque impulsion, la durée de la dernière impulsion (34) de la suite approchant la durée ($T_0$) d'une impulsion de fonctionnement (1, 2).

2. Procédé selon la revendication 1, caractérisé en ce que les mesures de température sont effectuées par l'injection d'un courant de mesure ($I_m$) donné dans le composant suivie d'une mesure de la tension ($V_j$) aux bornes de la jonction du composant, la température de jonction étant fonction de la tension ($V_j$) mesurée.

3. Procédé selon l'une quelconque des revendications précédentes, caractérisé en ce que la durée augmente d'une impulsion à l'autre selon un pas constant ($\Delta t$).

4. Procédé selon l'une quelconque des revendications précédentes, caractérisé en ce que la durée de la dernière impulsion (34) est égale à la durée ($T_0$) d'une impulsion de fonctionnement.

5. Procédé selon l'une quelconque des revendications 1 à 3, caractérisé en ce que le composant évoluant dans un régime d'onde continue, la dernière impulsion (63), d'ordre n, est telle qu'elle donne une mesure de température de jonction égale à celle produite par l'impulsion précédente, d'ordre n-1.

6. Procédé selon l'une quelconque des revendications précédentes, caractérisé en ce qu'une impulsion de test est appliquée une fois que la hausse de température provoquée par l'impulsion précédente est retombée à une température de référence ($\theta_a$).

7. Procédé selon la revendication 6, caractérisé en ce que la température de référence est la température ambiante ($\theta_a$).

8. Procédé selon l'une quelconque des revendications 2 à 7, caractérisé en ce que, le composant évoluant dans un régime impulsionnel, le courant de mesure ($I_m$) est maintenu dans le composant pendant la durée $T_1$ comprise entre une impulsion de fonctionnement (1) et la suivante (2), pendant cette durée $T_1$ des valeurs de tension de jonction continuant à être échantillonnées pour déterminer des points de mesure de température de jonction entre le deux impulsions (1,2).

9. Procédé selon l'une quelconque des revendications précédentes, caractérisé en ce que dans une zone inter-impulsions, la mesure est effectuée comme dans une zone intra-impulsion en injectant successivement en des temps décalés des impulsions de courant nécessaires à la mesure de la température.

10. Dispositif pour la mise en oeuvre du procédé selon l'une quelconque des revendications précédentes, caractérisé en ce qu'il comporte :

    - des moyens de génération d'impulsions hyperfréquence de test de durées croissantes (82), ces impulsions étant appliquées à un composant hyperfréquence (81) ;

    - des moyens (83) d'injection d'un courant de mesure dans le composant (81) ;

    - des moyens (84) d'acquisition de la tension de jonction du composant ;

    - une mémoire (87) comportant une correspondance entre le tension de jonction du composant et sa température ;

    - un processeur (85) qui commande les moyens précités (82, 83, 84) par des interfaces appropriées, le programme de test étant inscrit dans la mémoire (87).

FIG.1

FIG.3a

FIG.3b

FIG.3c

FIG.3d

FIG.4

FIG.2

FIG.5

FIG.6a

FIG.6b

FIG.6c

FIG.7

85 PROCESSEUR

87 MÉMOIRE

84 MOYENS D'ACQUISITION DE LA TENSION DE JONCTION Vj

86

81 COMPOSANT

90

83 MOYENS D'INJECTION DE COURANT DE MESURE $I_m$

82 MOYENS DE GÉNÉRATION D'IMPULSIONS DE TEST DE DURÉES CROISSANTES

FIG.8

**EP 1 107 011 A1**

Office européen
des brevets

**RAPPORT DE RECHERCHE EUROPEENNE**

Numéro de la demande

EP 00 40 3300

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | BERLIOUX R.: "Le test des semiconducteurs de puissance" TOUTE L'ELECTRONIQUE,FR,SOCIETE DES EDITIONS RADIO. PARIS, no. 501, février 1985 (1985-02), pages 59-62, XP002143985 * page 59, colonne 2, ligne 1 - page 60, colonne 3, dernière ligne * | 1-10 | G01R31/26 |
| A | LEIFER M C: "JUNCTION TEMPERATURE MEASUREMENTS IN REVERSE-BIASED PIN DIODES" REVIEW OF SCIENTIFIC INSTRUMENTS,US,AMERICAN INSTITUTE OF PHYSICS. NEW YORK, vol. 65, no. 2, 1 février 1994 (1994-02-01), pages 472-476, XP000439442 ISSN: 0034-6748 * abrégé * | 1 | |
| A | EP 0 336 814 A (THOMSON CSF) 11 octobre 1989 (1989-10-11) * abrégé; figure 1 * | 1,10 | **DOMAINES TECHNIQUES RECHERCHES (Int.Cl.7)** G01R |

Le présent rapport a été établi pour toutes les revendications

| Lieu de la recherche | Date d'achèvement de la recherche | Examinateur |
|---|---|---|
| BERLIN | 2 avril 2001 | Hijazi, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

12

**ANNEXE AU RAPPORT DE RECHERCHE EUROPEENNE
RELATIF A LA DEMANDE DE BREVET EUROPEEN NO.**          EP 00 40 3300

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-04-2001

| Document brevet cité au rapport de recherche | Date de publication | Membre(s) de la famille de brevet(s) | Date de publication |
|---|---|---|---|
| EP 0336814    A | 11-10-1989 | FR    2629597 A | 06-10-1989 |

Pour tout renseignement concernant cette annexe : voir Journal Officiel de l'Office européen des brevets, No.12/82